# EUROPÄISCHE PATENTSCHRIFT

(11) **EP 1 508 786 B1**
(45) Veröffentlichungstag und Bekanntmachung des Hinweises auf die Patenterteilung: **17.04.2013**
(21) Anmeldenummer: 04010269.1
(22) Anmeldetag: 30.04.2004
(51) Int. Cl.: G01D 11/24, G01R 1/04, H05K 5/00

(54) **Gehäuse für ein Messgerät zum Einbau in Schalttafeln oder Schaltschränken**
Housing for a sensor to be built into a distribution panel or box
Boîtier pour un appareil de mesures incorporable dans un tableau ou coffret de distribution

(30) Priorität: 18.08.2003 DE 20312919 U
(43) Veröffentlichungstag der Anmeldung: 23.02.2005
(73) Patentinhaber: General Elektronik GmbH, 39167 Hohendodeleben (DE)
(72) Erfinder: Schnepf, Norbert, 90547 Stein (DE); Meiler, Ernst, 90614 Ammerndorf (DE)
(74) Vertreter: Küchler, Stefan

(56) Entgegenhaltungen:
- DE-A1- 2 325 080
- DE-A1- 2 905 318
- GB-A- 2 013 889

## Beschreibung

Die Erfindung richtet sich auf ein vorzugsweise in Schalttafeln, -schränken od. dgl. einbaubares Gehäuse eines Meßgeräts mit einem vorzugsweise analogen Meßwerk und einem austauschbaren Skalenträger, umfassend ein rückwärtiges Gehäuseteil sowie ein daran festlegbares Frontelement mit einer transparenten Frontplatte, wobei an einer Seite des rückwärtigen Gehäuseteils eine langgestreckte, in der Ebene des Skalenträgers liegende Ausnehmung zur Aufnahme einer zwecks Austausch des Skalenträgers lösbaren Abdeckung vorgesehen ist, die aus einem langgestreckten, auf eine Stirnseite des Skalenträgers aufsteckbaren Mittelteil besteht, an dessen Schmalseiten sich je ein etwa rechtwinklig dazu verlaufender Schenkel anschließt.

Ein gattungsgemäßes Gehäuse ist der deutschen Offenlegungsschrift 33 21 299 und 29 05 318 zu entnehmen. Dort ist ein dosenförmiger Körper vorgesehen, der das eigentliche Meßinstrument aufnimmt. Dieser dosenförmige Körper weist einen seitlichen Schlitz auf, durch den eine kleine Platte eingeführt werden kann, welche die Meßskala trägt. Das Verschließen dieses Schlitzes erfolgt durch ein entsprechendes Element, das eingerastet wird. Diesem Einrasten dienen zwei hakenförmige Fortsätze an der Innenseite dieses Abdeckelements, die jeweils eine der beiden Stirnseiten des Schlitzes an dessen Innenseite umgreifen und sich dadurch verhaken. Damit dieses Abdeckelement zum Wechseln der Meßskala entfernt werden kann, sind an seinen Stirnseiten zwei Umbiegungen vorhanden, welche die betreffende Außenkante des dosenförmigen Gehäusekörpers umgreifen. Diese Anordnung ist jedoch insofern problematisch, als hier vergleichsweise kurze Kriechstrecken von dem üblicherweise aus Aluminium oder einem anderen Metall gefertigten Skalenträger bis zur Außenseite des Gehäuses vorhanden sind. Die Länge dieser Kriechstrecken ist wohl nicht länger als etwa die halbe Breitenerstreckung des in dem dosenförmigen Gehäuseteil vorgesehenen Schlitzes quer zu dessen Längsrichtung, da der Mittelteil des Abdeckelements ebenfalls eine kaum größere Breite aufweist.

Dies ist insofern nicht unkritisch, da an solchen Meßinstrumenten Spannungen in der Größenordnung bis zu etwa 1.000 Volt anliegen können, die im Fall einer Kontaktbrücke schnell bis zu dem Skalenträger gelangen. Da andererseits Handhabungen des Bedienungspersonals während des Betriebs vorgenommen werden, besteht ohne eine sichere Trennung zwischen der Meßspannung und dem Potential des Bedienungsperonals eine erhebliche Gefahr für das Leben und die Gesundheit solcher Personen.

Aus diesen Nachteilen des beschriebenen Standes der Technik resultiert das die Erfindung initiierende Problem, Vorkehrungen zu treffen, damit keine lebensgefährlichen Berührungsspannungen an der Außenseite eines gattungsgemäßen Gehäuses für ein Einbau-Meßgerät anliegen können.

Die Lösung dieses Problems gelingt dadurch, dass an der Innenseite der lösbaren Abdeckung vor und/oder hinter einem Skalenträger steg-, feder- oder lamellenförmige Vorsprünge und/oder nutförmige Vertiefungen angeordnet sind.

Derartige Profilierungen dienen dazu, die Kriechstrecke zwischen dem Skalenträger und der Außenseite des Gehäuses zu verlängern, da entsprechende Oberflächenströme entlang der Vorsprünge und/oder Vertiefungen fließen müssen.

Wenn der (die) steg-, feder- oder lamellenförmige(n) Vorsprung (Vorsprünge) und/oder die nutförmige(n) Vertiefung(en) mit dazu kompatiblen, vorzugsweise etwa komplementären Vertiefungen und/oder Vorsprüngen an der außenliegenden Seite des Frontelements und/oder des rückwärtigen Gehäuseteils korrespondieren, so ergibt sich beim Einfügen des Abdeckelements ein verzahnungsartiger Eingriff mit den Profilierungen des jeweils anderen Teils, der dazu führt, dass die Luft- oder Funkenstrecke zwischen Skalenträger und Außenseite des Gehäuses erheblich verlängert wird, wodurch die Gefahr eines Überschlags deutlich gesenkt wird. Dadurch können Forderungen einschlägiger Vorschriften und Normen eingehalten werden.

Es hat sich als günstig erwiesen, dass die Länge des Mittelteils der lösbaren Abdeckung gleich oder allenfalls etwas kleiner ist als die Länge der dafür vorgesehenen Ausnehmung in dem rückwärtigen Gehäuseteil. Dadurch ist es möglich, die lösbare Abdeckung mitsamt deren seitlicher Schenkel vollständig in die Gehäuseausnehmung einsetzen zu können. Die seitlichen Schenkel dienen dazu, eine verkürzte Kriech- oder Luftstrecke von den Eckbereichen des Skalenträgers an der lösbaren Abdeckung vorbei auszuschließen. Indem dieselben beim vollständigen Einsetzen der Abdeckung in die Ausnehmung des Gehäuses in letzteres eintauchen, verlängert sich auch die minimale Luft- oder Kriechstrecke von den seitlich anschließenden Bereichen des Skalenträgers zur Außenseite des Gehäuses, so dass an keiner Stelle eine konstruktiv vorgebbare, minimale Kriech- oder Luftstrecke zwischen Skalenträger und Gehäuseaußenseite unterschritten wird.

Es liegt im Rahmen der Erfindung, dass die Länge der Ausnehmung in dem Gehäuseteil für die Aufnahme einer lösbaren Abdeckung gleich oder größer ist als die betreffende Breite des Gehäuses abzüglich der Wandstärken der daran angrenzenden Gehäuseseiten. Diese Bemessungsregel korrespondiert mit der Größe, insbesondere Breite des Skalenträgers, da dieser durch die bspw. schlitzförmige Ausnehmung des Gehäuses hindurchpassen muß. Der Skalenträger erfährt üblicherweise eine Führung innerhalb von an der Innenseite des Gehäuses entlanglaufenden Nuten und ist daher meist etwas breiter als der lichte Querschnitt zwischen den einander gegenüberliegenden Gehäusewänden; entsprechend muß auch die dem Austausch des Skalenträgers dienende Gehäuseausnehmung bemessen sein.

An den Innenseiten der an die Ausnehmung des Gehäuseteils für die Aufnahme einer lösbaren Abdeckung angrenzenden Gehäuseseiten kann je eine etwa muldenförmige Vertiefung zur Aufnahme der seitlichen Schenkel der lösbaren Abdeckung vorgesehen sein. Diese muldenförmigen Vertiefungen dienen neben einer entsprechenden Verlängerung der Gehäuseausnehmung vor allem dem Zweck, die lösbare Abdeckung in eingesetztem Zustand lagemäßig zu stabilisieren. Zu diesem Zweck kann die Umrißform der muldenförmigen Vertiefungen der Umrißform der darin einzusetzenden Seitenschenkel der lösbaren Abdeckung angepaßt sein.

Infolge der muldenförmigen Vertiefungen reduziert sich an den betreffenden Stellen die Stärke der an die Ausnehmung für die Aufnahme einer lösbaren Abdeckung angrenzenden Seitenwände des Gehäuses. Zwar könnte zur Kompensation eine Verdickung an der Gehäuseaußenseite vorgesehen sein, wodurch allerdings das Einbaumaß verändert würde.

Ein bewährtes Maß für die reduzierte Wandstärke im Bereich der muldenförmigen Vertiefungen liegt bei etwa zwei Drittel der Wandstärke außerhalb dieser Vertiefungen oder unterhalb dieses Wertes, vorzugsweise bei der Hälfte dieser Wandstärke oder darunter, insbesondere bei einem Drittel dieser Wandstärke oder weniger. Da diese Bereiche keine tragende Funktion erfüllen, sondern ausschließlich einer Verlängerung der Kriech- bzw. Luftstrecke dienen und außerdem von den darunter liegenden Seitenschenkeln der lösbaren Abdeckung gestützt werden, ist eine entsprechende Querschnittsreduzierung unkritisch.

Ein an der Innenseite der lösbaren Abdeckung entlanglaufender Schlitz dient dem Einstecken der Stirnseite eines Skalenträgers und damit dessen Fixierung bzw. Halterung. Aus diesem Grund sollte die Breite bzw. Dicke dieses Schlitzes gleich oder sogar etwas kleiner sein als die Stärke des Skalenträgers, so dass dieser eingeklemmt und damit reibschlüssig fixiert wird.

Dieser Erfindungsgedanke läßt sich dahingehend weiterbilden, dass der dem Einstecken der Stirnseite eines Skalenträgers dienende Schlitz an der Innenseite der Abdeckung von deren Mittelteil nahtlos in die daran anschließenden Schenkel übergeht und sich bis zu deren freien Enden fortsetzt. Die den Schlitz berandenden Stege, Lippen oder sonstige Fortsätze dienen ebenfalls der Verlängerung der Kriech- oder Luftstrecke. Es ist daher wichtig, dass diese Fortsätze gerade auch im Bereich der Ecken keinerlei Unterbrechung erfahren, damit auch dort keine Verkürzung der Kriech- oder Luftstrecke eintritt.

Vorzugsweise befinden sich die weiter oben erwähnten, steg-, feder- oder lamellenförmige Vorsprünge und/oder nutförmige Vertiefungen an der Innenseite der lösbaren Abdeckung vor und/oder hinter dem daran entlanglaufenden Schlitz zum Einstecken der Stirnseite eines Skalenträgers bzw. vor und/oder hinter den diesen berandenden Stege, Lippen oder sonstigen Fortsätze. Dabei wird im allgemeinen einer Konstruktion der Vorzug zu geben sein, bei welcher derartige Elemente zur Verlängerung der Kriech- oder Luftstrecke vor und hinter dem Einsteckschlitz für den Skalenträger vorgesehen sind, so dass an keiner der beiden Längsseiten der Gehäuseausnehmung ein Überschlag auftreten kann.

Ein besonders einfacher, konstruktiver Aufbau ergibt sich, wenn der (die) steg-, feder- oder lamellenförmige(n) Vorsprung (Vorsprünge) und/oder nutförmige(n) Vertiefung(en) parallel zu dem Schlitz zum Einstecken der Stirnseite eines Skalenträgers verläuft (verlaufen). Außerdem ergeben sich dadurch gleichbleibende Verhältnisse entlang des gesamten Abschnitts der Skalenträgerkante.

Weitere Vorteile ergeben sich dadurch, dass der (die) steg-, feder- oder lamellenförmige(n) Vorsprung (Vorsprünge) und/oder die nutförmige(n) Vertiefung(en) einen über ihre Tiefe etwa konstanten Querschnitt haben oder sich von ihrer Basis (im Bereich der umgebenden Innenseite) zu ihrem davon entfernten Ende (freie Federstirnseite bzw. Nutboden) verjüngen. Solchenfalls wird das Zusammenstecken bzw. Lösen solcher Teile nicht behindert oder gar gefördert. Dies ist nicht unwichtig, da beim Aufsetzen der erfindungsgemäßen Abdeckung deren Unterseite und überdies die Position von dort angeordneten Vorsprüngen oder Vertiefungen meist nicht einsehbar ist.

Ferner kann vorgesehen sein, dass die Tiefenerstreckung des (der) steg-, federoder lamellenförmige(n) Vorsprungs (Vorsprünge) und/oder der nutförmigen Vertiefung(en) in Richtung zur Vorderseite des Gehäuses hin abnimmt. Sofern mehrere solche Profilelemente vorhanden sind, müssen dieselben nicht die selbe Geometrie aufweisen; es sollte nur sichergestellt sein, dass die Abdeckung ggf. leicht aufsetzbar ist und dabei insbesondere deren unterseitige Profilierungen ggf. mit dazu etwa komplementären Profilierungen der übrigen Gehäuseteile leicht in Eingriff bringbar sind.

Schließlich entspricht es der Lehre der Erfindung, dass die Innenseite der lösbaren Abdeckung und/oder die außenliegende Seite eines Frontrahmens in Richtung zur Vorderseite des Gehäuses hin nach außen divergiert. Man kann sich damit an eine entsprechend geneigte Innenseite der Blende anpassen und erreicht dadurch eine Verlängerung der Kriechstrecke.

Weitere Merkmale, Einzelheiten, Vorteile und Wirkungen auf der Basis der Erfindung ergeben sich aus der nachfolgenden Beschreibung einer bevorzugten Ausführungsform der Erfindung sowie anhand der Zeichnung. Hierbei zeigt:
- Fig. 1: eine perspektivische Ansicht eines Einbau-Meßgeräts mit einem erfindungsgemäßen Gehäuse;
- Fig. 2: einen Schnitt durch die Fig. 1 entlang der Linie II - II;
- Fig. 3: einen Querschnitt durch das rückwärtige Gehäuseteil, abgebrochen dargestellt, mitsamt der davon gelösten Abdeckung; sowie
- Fig. 4: einen Schnitt durch die Fig. 3 entlang der Linie IV - IV.

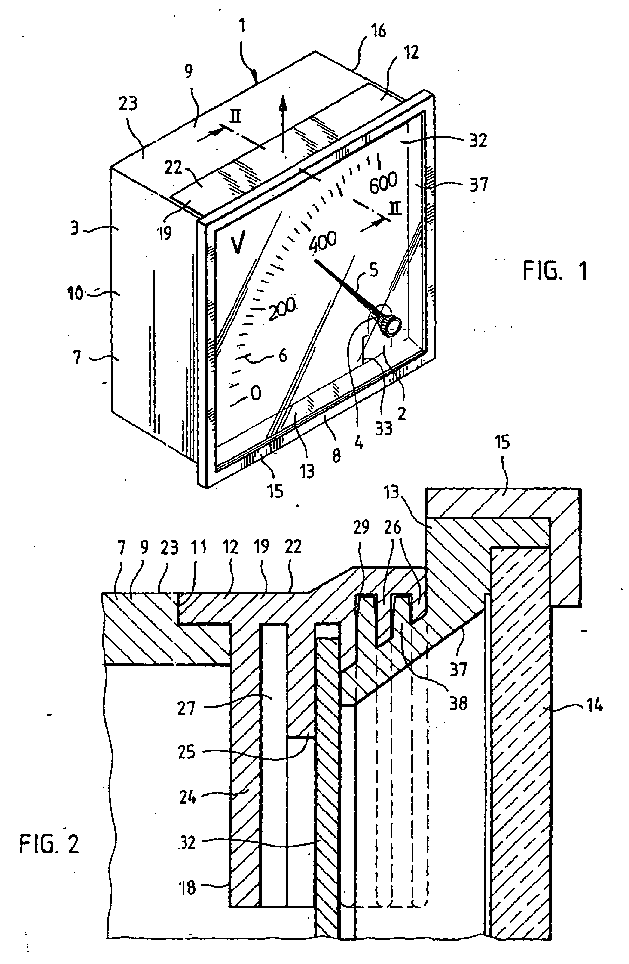

In Fig. 1 ist beispielhaft ein analoges Meßgerät 1 wiedergegeben; die Erfindung läßt sich allerdings auch bei digitalen Meßgeräten realisieren. Das Meßgerät 1 umfaßt ein Meßwerk 2, bspw. ein Drehspul- oder Dreheisenmeßwerk, dessen statischer Teil in einem Gehäuse 3 verankert ist, während sein verdrehbarer Teil 4 mit einem Zeiger 5 verbunden ist. Der Ausschlag dieses Zeigers 5 kann gegenüber einer Skala 6 abgelesen werden.

Je nach elektrischer Beschaltung des Meßwerks 2 bspw. mit Vorwiderständen, einem Eingangs-Spannungsteiler oder einem parallelgeschalteten Shunt-Widerstand kann ein und dasselbe Meßwerk für unterschiedliche Strom- oder Spannungsbereiche verwendet werden. Bei einer derartigen Anpassung ist neben einer Änderung der elektrischen Beschaltung ein Austausch der Skala 6 erforderlich.

Das Gehäuse 3 besteht aus einem Mantel und einer flachen Rückseite, die zu einem etwa dosenförmigen, rückwärtigen Teil 7 zusammengesetzt sind, welches das Meßwerk, die elektrischen Beschaltungselemente, sowie die Skala 6 aufnimmt und hält und ferner - vorzugsweise an seiner Rückseite - die elektrischen Kontaktelemente trägt, und aus einem die vorderseitige Öffnung desselben verschließenden Frontelement 8.

Der Rahmen des rückwärtigen Teils 7 mündet an seiner Vorderseite in eine rahmenförmige Blende 13. Das davor gesetzte Frontelement 8 umfaßt die Glasplatte 14, die an der Blende 13 durch Aufschnappen des Frontrahmens 15 festgelegt wird.

An die - bei der dargestellten Ausführungsform etwa quadratische - Rückwand des rückwärtigen Gehäuseteils 7 schließen sich eine der Anzahl der durch Ecken voneinander getrennten Umfangskanten der Rückwand entsprechende Zahl von Seitenwänden 9, 10 an. In einer Seitenwand 9 ist eine Ausnehmung 11 vorhanden, die mit einem Abdeckelement 12 verschließbar ist.

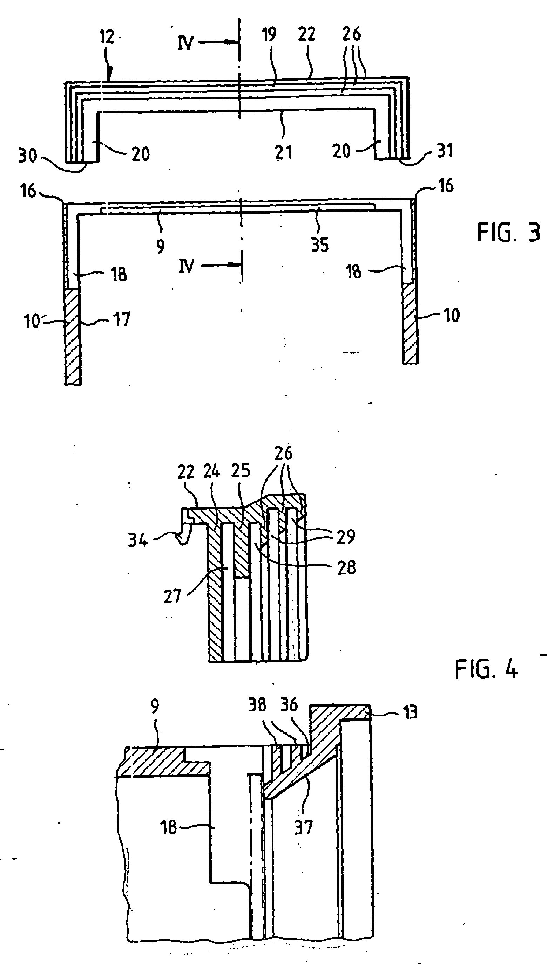

Die Ausnehmung 11 hat eine langgestreckte, etwa rechteckige Form. Wie Fig. 3 zu entnehmen ist, erstreckt sich die Ausnehmung 11 über nahezu die gesamte Breite der oberen Seitenwand 9 bis kurz vor die Kante 16 zu der jeweils angrenzenden Seitenwand 10. Man erkennt aus Fig. 3, dass der verbleibende Abstand zu einer Gehäusekante 16 kleiner ist als die Stärke einer Seitenwand 10, so dass sich an der Innenseite 17 dieser Seitenwände 10 je eine muldenförmige Vertiefung 18 ergibt. Die Ausnehmung 11 ist zu der Vorderseite des rückwärtigen Gehäuseteils 7 hin offen.

Das die Ausnehmung 11 verschließende Abdeckelement 12 hat eine U-förmige Grundgestalt mit einem Mittelsteg 19 und zwei daran anschließenden Seitenschenkeln 20. Entsprechend dieser Geometrie sollen die von diesem U umgriffenen Flächen als Innenseite 21 des Abdeckelements 12 bezeichnet werden, die gegenüberliegenden Flächen als Außenseite 22. Die Außenabmessungen des Mittelstegs 19 entsprechen ziemlich genau dem Umriß der Ausnehmung 11, die Außenabmessungen der Seitenschenkel 20 dem Umriß der muldenförmigen Vertiefungen 18 an der Innenseite 17 der Seitenwände 10. Dadurch läßt sich das Abdeckelement 12 etwa paßgenau in die Ausnehmung 11 einsetzen und wird dort durch die in die Mulden 18 eingreifenden Seitenschenkel 20 lagemäßig fixiert, derart, dass die Außenseite 22 des Mittelstegs 19 mit der Außenseite 23 der oberen Seitenwand 9 des rückwärtigen Gehäuseteils 7 bündig abschließt. Wie die Fig. 2 und 4 erkennen lassen, kann die Außenseite 22 des Mittelstegs auch einen stufigen oder auf sonstigem Wege abgesetzten Verlauf haben, insbesondere wenn dies der Form des rückwärtigen Gehäuseteils 7 entspricht.

Von besonderer Bedeutung ist die Gestaltung der Innenseite 21 des Abdeckelements 12. Wie die Fig. 2 und 4 erkennen lassen, sind dort mehrere Stege 24, 25, 26 vorgesehen, jeweils mit dazwischen liegenden Nuten 27, 28, 29. Diese Stege 24-26 und Nuten 27-29 setzen sich nahtlos und mit jeweils gleichbleibendem Querschnitt von einem Schenkelende 30 über den betreffenden Seitenschenkel 20, den Mittelsteg 19 und den anderen Seitenschenkel 20 bis zu dem gegenüberliegenden Schenkelende 31 hin fort. Der Verlauf dieser Stege 24-26 und Nuten 27-29 ist jeweils parallel zu der Ebene des Frontelements 8.

Die Skala 6 ist auf einem plattenförmigen Skalenträger 32 angebracht, bspw. aufgedruckt. Diese Platte 32 kann aus Metall bestehen, bspw. Aluminium. Die Form Ihres Umrisses entspricht etwa dem der frontseitigen Glasplatte 14, jedoch kann die Größe ihrer Fläche etwas kleiner sein als die Fläche der Glasplatte 14. Ihre Stärke kann bspw. 0,5 bis 2,0 mm betragen. An ihrer Unterkante ist vorzugsweise eine schlitzförmige Ausnehmung 33 zum Durchtritt des den Zeiger 5 tragenden Teils 4 des Meßwerks 2 sein.

Der Skalenträger 32 ist in einem an der Innenseite 17 der Seitenwände 10 entlanglaufenden Schlitz geführt. Dieser Schlitz geht im Bereich der oberen Gehäusekanten 16 über in die muldenförmigen Vertiefungen 18. Da die Breite des Skalenträgers 32 gleich oder kleiner ist als die lichte Weite zwischen den einander gegenüberliegenden Mulden 18, kann der Skalenträger durch die schlitzförmige Ausnehmung 11 nach oben aus dem Gehäuse 7,8 herausgezogen werden. Zu diesem Zweck hat eine Nut 28 an der Innenseite 21 des Abdeckelements 12 eine zwischen den Nutseitenwänden gemessene Stärke, die gleich oder etwas kleiner ist als die Stärke des plattenförmigen Skalenträgers 32. Da auch der lichte Abstand zwischen den einander gegenüberliegenden Böden dieser Nut 28 in den beiden Seitenschenkeln 20 gleich oder etwas kleiner ist als die Breite des Skalenträgers 32, kann dieser in die betreffende Nut 28 klemmend eingesetzt werden.

In einem an die Ausnehmung 11 angrenzenden Bereich der Außenseite 23 der betreffenden Seitenwand 9 des rückwärtigen Gehäuseteils kann eine muldenförmige Vertiefung vorhanden sein, die es erlaubt, mit der Klinge eines Schraubendrehers unter das Abdeckelement 12 zu fahren und dieses nach oben aus der Ausnehmung 11 herauszuheben. Dabei wird der von dem Abdeckelement 12 klemmend gehaltene Skalenträger 32 mit emporgezogen. Normalerweise werden Abdeckelement 12 und Skalenträger 32 bereits durch die nach unten wirkende Schwerkraft in ihrer Position gehalten. Zusätzlich kann bspw. an der rückwärtigen Kante des Abdeckelements 12 ein haken- oder leistenförmiger Fortsatz 34 vorgesehen sein, der bspw. mit einem dazu komplementären Element 35 an der betreffenden Seite der Ausnehmung 11 zusammenwirkt, um das Abdeckelement 12 darin einzurasten. Eine solche, komplementäre Leiste 35 kann überdies von einem querschnittlich verjüngten Bereich des Abdeckelements 12 übergriffen werden, so dass dieses sich auf dieser Leiste 35 abstützt und dadurch zusätzlich stabilisiert wird.

Die jeweils vor und hinter der Nut 28 liegenden Stege 24-26 und Nuten 27, 29 dienen der Verlängerung der Kriechstrecke von dem Skalenträger 32 bis zu der Außenseite 23 des Gehäuses 7, 8. Dabei können vor bzw. hinter dem Skalenträger 32 jeweils zusätzlich zu dem die Nut 28 für den Skalenträger 32 begrenzenden Steg 25, 26 jeweils noch ein oder mehrere Stege 24, 26 vorhanden sein.

Wie Fig. 4 zeigt, ist hinter dem Steg 25 noch ein Steg 24 vorgesehen, dessen Höhe allerdings etwa doppelt so groß ist wie die Höhe des Stegs 25. Die Länge und Position der Stege 24, 25 kann variiert werden, um die benötigte Länge der Isolierstrecke zu realisieren.

Vor dem Skalenträger 32 befinden sich zusätzlich zu dem die Nut 28 begrenzenden Steg 26 noch zwei weitere Stege 26. Deren freie Enden weichen jedoch von dem Skalenträger 32 in Richtung nach vorne zu der Glasplatte 14 hin nach außen zurück, wie dies dem dortigen Verlauf der Außenseite 36 der Blende 13 entspricht. Denn die Innenseite 37 der Blende 13 divergiert ebenfalls von dem Skalenträger 32 zu der Glasplätte 14 hin, um auch aus schrägen Betrachtungswinkeln das optimale Ablesen der Skala 6 und der Stellung des Zeigers 5 zu ermöglichen. Infolge einer in ihrem rückwärtigen Bereich der Blende 13 etwa konstanten Stärke derselben überträgt sich diese Neigung auch auf ihre Außenseite 36.

Da die Höhe der vorderen Stege 26 daher durch das dortige Blendenelement 13 begrenzt ist, ist insgesamt eine größere Steganzahl vorhanden als hinter dem Skalenträger, wo die Steghöhe nicht begrenzt ist. Außerdem sind an der Außenseite 36 des rahmenförmigen Blendenelements 13 zusätzlich Stege 38 angeformt, die lage- und größenmäßig mit den Nuten 29 zwischen den vorderen Stegen 26 des Abdeckelements 12 korrespondieren und beim Einsetzen des Abdeckelements 12 in die Ausnehmung 11 in eben diese Nuten 29 eintreten. Die solchermaßen gebildete Verzahnung hat eine weitere Verlängerung der Luftstrecke von dem Skalenträger 32 bis zu der Außenseite 23 des Gehäuses 7, 8 zur Folge und reduziert damit die Gefahr eines Spannungsüberschlags.

Die freien Stirnseiten der Stege 26 und/oder der Stege 38 können verjüngt und/oder abgerundet sein, um das verzahnte Zusammenfügen dieser Stege 26, 38 beim Einstecken des Abdeckelements 12 in die Ausnehmung 11 zu erleichtern.

Wenn die Länge der Seitenschenkel 20 des Abdeckelements etwa dieser (mäanderförmig gewundenen) Luftstrecke entspricht, so ergibt sich auch im Bereich der Stirnseiten der Ausnehmung 11 eine entsprechende Luftstreckenlänge. Ähnliches läßt sich für die rückwärtige Kante der Ausnehmung 11 erreichen, indem die Höhe des Stegs 24 ausreichend bemessen wird; im Grenzfall kann die Höhe dieses Stegs 24 etwa der Länge der Seitenschenkel 20 des Abdeckelements 12 entsprechen.

## Patentansprüche

1. Gehäuse (3), vorzugsweise zum Einbau in Schalttafeln, -schränken od. dgl., für ein Meßgerät (1) mit einem vorzugsweise analogen Meßwerk (2 und einem austauschbaren Skalenträger (32), umfassend ein rückwärtiges Gehäuseteil (7) sowie ein daran festlegbares Frontelement (8) mit einer transparenten Frontplatte (14), wobei an einer Seite (9) des rückwärtigen Gehäuseteils (7) und/oder des Frontelements (8) eine langgestreckte, in der Ebene des Skalenträgers (32) liegende Ausnehmung (11) zur Aufnahme einer Abdeckung (12) vorgesehen ist, die aus einem langgestreckten, auf eine Stirnseite des Skalenträgers (32) aufsteckbaren Mittelteil (19) besteht, an dessen Schmalseiten sich je ein etwa rechtwinklig dazu verlaufender Schenkel (20) anschließt, wobei an der Innenseite (21) der lösbaren Abdeckung (12) ein an der Innenseite (21) der Abdeckung (12) entlanglaufender Schlitz (28) zum Einstecken der Stirnseite eines Skalenträgers (32).vorgesehen ist, der durch Stege (25,26) berandet ist, **dadurch gekennzeichnet, dass**
a) die Abdeckung (12) zwecks Austausch des Skalenträgers (32) lösbar ist; wobei
b) an der Innenseite (21) der lösbaren Abdeckung (12) vor und/oder hinter einem Skalenträger (32) steg-, feder- oder lamellenförmige Vorsprünge (24-26) und/oder nutförmige Vertiefungen (27, 29) angeordnet sind, derart, dass zusätzlich zu den den Schlitz (28) zum Einstecken des Skalenträgers (32) berandenden Stegen (25,26) noch ein oder mehrere Stege (24,26) vorhanden sind.

2. Gehäuse nach Anspruch 1 für ein Meßgerät, **dadurch gekennzeichnet, dass** der (die) steg-, feder- oder lamellenförmige(n) Vorsprung (Vorsprünge) (24-26) und/oder die nutförmige(n) Vertiefung(en) (27, 29) mit dazu kompatiblen, vorzugsweise etwa komplementären Vertiefungen und/oder Vorsprüngen (38) an der außenliegenden Seite (36) des Frontelements (8, 13) und/oder des rückwärtigen Gehäuseteils (7) korrespondieren.

3. Gehäuse nach Anspruch 1 oder 2 für ein Meßgerät, **dadurch gekennzeichnet, dass** die Länge des Mittelteils (19) der lösbaren Abdeckung (12) gleich oder allenfalls etwas kleiner ist als die Länge der dafür vorgesehenen Ausnehmung (11) in dem rückwärtigen Gehäuseteil (7).

4. Gehäuse nach einem der Ansprüche 1 bis 3 für ein Meßgerät, **dadurch gekennzeichnet, dass** die Länge der Ausnehmung (11) in dem rückwärtigen Gehäuseteil (7) für die Aufnahme einer lösbaren Abdeckung (12) größer ist als die betreffende Breite des rückwärtigen Gehäuseteils (7) abzüglich der Wandstärken der daran angrenzenden Gehäuseseiten (10).

5. Gehäuse nach einem der vorhergehenden Ansprüche für ein Meßgerät, **dadurch gekennzeichnet, dass** an den Innenseiten (17) der an die Ausnehmung (11) des rückwärtigen Gehäuseteils (7) für die Aufnahme einer lösbaren Abdeckung (12) angrenzenden Gehäuseseiten (10) je eine etwa muldenförmige Vertiefung (18) zur Aufnahme der seitlichen Schenkel (20) der lösbaren Abdeckung (12) vorgesehen ist.

6. Gehäuse nach Anspruch 5 für ein Meßgerät, **dadurch gekennzeichnet, dass** die Stärke der an die Ausnehmung (11) für die Aufnahme einer lösbaren Abdeckung (12) angrenzenden Seitenwände (10) des rückwärtigen Gehäuseteils (7) im Bereich der muldenförmigen Vertiefungen (18) reduziert ist.

7. Gehäuse nach Anspruch 6 für ein Meßgerät, **dadurch gekennzeichnet, dass** die reduzierte Wandstärke im Bereich der muldenförmigen Vertiefungen (18) etwa gleich ist oder kleiner als zwei Drittel der Wandstärke außerhalb dieser Vertiefungen (18), vorzugsweise gleich oder kleiner als die Hälfte dieser Wandstärke, insbesondere gleich oder kleiner als ein Drittel dieser Wandstärke.

8. Gehäuse nach einem der vorhergehenden Ansprüche für ein Meßgerät, **dadurch gekennzeichnet, dass** der dem Einstecken der Stirnseite eines Skalenträgers (32) dienende Schlitz (28) an der Innenseite (21) der Abdeckung (12) von deren Mittelteil (19) nahtlos in deren daran anschließende Schenkel (20) übergeht und sich bis zu den freien Enden (30, 31) derselben fortsetzt.

9. Gehäuse nach einem der vorhergehenden Ansprüche für ein Meßgerät, **dadurch gekennzeichnet, dass** die an der Innenseite (21) der lösbaren Abdeckung (12) angeordneten, steg-, feder- oder lamellenförmigen Vorsprünge (24-26) und/oder nutförmigen Vertiefungen (27, 29) vor und/oder hinter dem daran entlanglaufenden Schlitz (28) zum Einstecken der Stirnseite eines Skalenträgers (32) plaziert sind.

10. Gehäuse nach Anspruch 9 für ein Meßgerät, **dadurch gekennzeichnet, dass** der (die) steg-, feder- oder lamellenförmige(n) Vorsprung (Vorsprünge) (24-26) und/oder nutförmige(n) Vertiefung(en) (27, 29) parallel zu dem Schlitz (28) zum Einstecken der Stirnseite eines Skalenträgers (32) verlaufen.

11. Gehäuse nach Anspruch 9 oder 10 für ein Meßgerät, **dadurch gekennzeichnet, dass** der (die) steg-, feder- oder lamellenförmige(n) Vorsprung (Vorsprünge) (24-26) und/oder die nutförmige(n) Vertiefung(en) (27, 29) einen über ihre Höhe bzw. Tiefe etwa konstanten Querschnitt haben oder sich von ihrer Basis (im Bereich der umgebenden Innenseite 21, 36) zu ihrem davon entfernten Ende (freie Federstirnseite bzw. Nutboden) verjüngen.

12. Gehäuse nach einem der Ansprüche 9 bis 11 für ein Meßgerät, **dadurch gekennzeichnet, dass** die Tiefenerstreckung des (der) steg-, feder- oder lamellenförmige(n) Vorsprungs (Vorsprünge) (24-26) und/oder der nutförmigen Vertiefung(en) (27, 29) in Richtung zur Vorderseite (8, 14) des Gehäuses hin abnimmt.

13. Gehäuse nach einem der vorhergehenden Ansprüche für ein Meßgerät, **dadurch gekennzeichnet, dass** die Innenseite (21) der lösbaren Abdeckung (12) und/oder die seitlich außen liegende Seite (36) der Blende (13) des Frontelements (8) in Richtung zu der Vorderseite (8, 14) des Gehäuses (3) hin nach seitlich außen divergiert.

## Claims

1. Housing (3), preferably for the installation in distribution panels, distribution boxes or the like, for a measuring device (1) with a preferred analogue measuring mechanism (2) and a convertible scale support (32), comprising a rearward housing part (7) as well as a front element fixable thereon (8) and equipped with a transparent front plate (14), whereby at one side (9) of the rearward housing part (7) and/or of the front element (8), there is provided an elongated recess (11) within the plain of the scale support (32) for receiving a cover (12), which consists of an elongated central part (19) pluggable onto an end face of the scale support (32) and flanked at its narrow sides by a leg (20) running at right angle thereto an, whereby a slot (28) running along the inner surface (21) of the cover (12) is provided at the inner surface (21) of the cover (12) for insertion of the end face of a scale support (32), which is delimited by webs (25,26), **characterized in that**
a) the cover (12) is exchangeable for the purpose of replacement of the scale support (32); whereby
b) at the inner surface (21) of the detachable cover (12) in front of and/or behind a scale support (32), there are provided web-like, tongue-like or lamellar protrusions (24-26) and/or groove-like indentations (27, 29), in such way that one or more webs (24,26) exist in addition to the webs (25,26) delimiting the slot (28) for insertion of the scale support (32).

2. Housing according to claim 1 for a measuring device, **characterized in that** the web-like, tongue-like or lamellar protrusion(s) (24-26) and/or the groove-like indentation(s) (27, 29) correspond to compatible, preferably complementary indentations and/or protrusions (38) at the outer side (36) of the front element (8, 13) and/or of the rearward housing part (7).

3. Housing according to claim 1 or 2 for a measuring device, **characterized in that** the length of the central part (19) of the detachable cover (12) is identical to or, at the utmost, somewhat smaller than the length of the recess (11) in the rearward housing part (7) provided for it.

4. Housing according to one of claims 1 to 3 for a measuring device, **characterized in that** the length of the recess (11) in the rearward housing part (7) for receiving a detachable cover (12) is greater than the regarding width of the rearward housing part (7) deducted the wall thicknesses of the adjacent lateral housing sides (10).

5. Housing according to one of the preceding claims for a measuring device, **characterized in that** a trough-shaped indentations (18) for receiving the lateral legs (20) of the detachable cover (12) is provided at all housing sides (10) bordering the inner sides (17) of the recess (11) of the rearward housing part (7).

6. Housing according to claim 5 for a measuring device, **characterized in that** the thickness of the lateral walls (10) of the rearward housing part (7) adjacent to the recess (11) for the reception of a detachable cover (10) is reduced in the area of the trough-shaped indentations (18).

7. Housing according to claim 6 for a measuring device, **characterized in that** the reduced wall thickness in the area of the trough-shaped indentations (18) is approximately identical to or smaller than two thirds of the wall thickness beyond these indentations (18), preferably identical to or smaller than half of this wall thickness, especially identical to or smaller than one third of this wall thickness.

8. Housing according to one of the preceding claims for a measuring device, **characterized in that** the slot (28) at the inner side (21) of the cover (12), which serves for insertion of the end face of a scale support (32), segues seamlessly at the inner side (21) of the cover (12) from the central part (19) thereof into the adjacent legs (20) and extends up to the free ends (30, 31) thereof.

9. Housing according to one of the preceding claims for a measuring device, **characterized in that** the web-like, tongue-like or lamellar protrusion(s) (24-26) and/or the groove-like indentation(s) (27, 29) arranged at the inner side (21) of the detachable cover (12) are located in front of and/or behind the slot (28) for insertion of the end face of a scale support (32) extending along them.

10. Housing according to claim 9 for a measuring device, **characterized in that** the web-like, tongue-like or lamellar protrusion(s) (24-26) and/or the groove-like indentation(s) (27, 29) extend parallel to the slot (28) for insertion of the end face of a scale support (32).

11. Housing according to claim 9 or 10 for a measuring device, **characterized in that** the web-like, tongue-like or lamellar protrusion(s) (24-26) and/or the groove-like indentation(s) (27, 29) have a constant cross section over their height or depth, respectively, or taper from their base (in the area of the surrounding inner side 21, 36) to their end (free end face of the tongue or ground of the groove, respectively) distant therefrom.

12. Housing according to one of claims 9 to 11 for a measuring device, **characterized in that** the depth extension of the web-like, tongue-like or lamellar protrusion(s) (24-26) and/or the groove-like indentation(s) (27, 29) decreases in a direction to the front end (8, 14) of the housing.

13. Housing according to one of the preceding claims for a measuring device, **characterized in that** the inner side (21) of the detachable cover (12) and/or the outer side (36) of the frame (13) of the front element (8) diverges in a direction toward the front end (8, 14) of the housing (3) lateral outwardly.

## Revendications

1. Boîtier (3), de préférence pour le montage dans des tableaux de commande, armoires de commande ou similaire, pour un appareil de mesure (1) avec un mécanisme de mesure de préférence analogique (2) et un support de cadran (32) interchangeable, comprenant une partie de boîtier arrière (7) ainsi qu'un élément frontal pouvant y être fixé (8) avec une plaque frontale transparente (14), où sur une face (9) de la partie de boîtier arrière (7) et/ou de l'élément frontal (8) est prévu un évidement (11) allongé, se trouvant au niveau du support de cadran (32) pour le logement d'un couvercle (12) qui consiste en une partie médiane (19) allongée enfichable sur une face frontale du support de cadran (32), respectivement un côté latéral (20) s'étendant approximativement perpendiculairement est relié à ses petits côtés où, sur la face intérieure (21) du couvercle (12) amovible, une fente (28) s'étendant sur la longueur de la face intérieure (21) du couvercle (12) est prévue pour introduire la face frontale d'un support de cadran (32) qui est bordé par des nervures (25, 26), **caractérisé en ce que**
a) le couvercle (12) est amovible à des fins de remplacement du support de cadran (32) ; où
b) sur la face intérieure (21) du couvercle (12) amovible en amont et/ou en aval d'un support de cadran (32) sont disposées des saillies (24-26) en forme de nervure, de ressort ou de lamelle et/ou des cavités (27, 29) en forme de rainure de façon à ce que, outre les nervures (25, 26) bordant la fente (28) pour l'introduction du support de cadran (32), il y ait une ou plusieurs autres nervures (24, 26).

2. Boîtier selon la revendication 1 pour un appareil de mesure, **caractérisé en ce que** la/les saillie(s) (24-26) en forme de nervure(s), de ressort(s) ou de lamelle(s) et/ou la/les cavité(s) (27, 29) en forme de rainure(s) correspondent aux cavités compatibles, de préférence approximativement complémentaires, et/ou aux saillies (38) sur la face extérieure (36) de l'élément frontal (8, 13) et/ou de la partie de boîtier arrière (7).

3. Boîtier selon la revendication 1 ou 2 pour un appareil de mesure, **caractérisé en ce que** la longueur de la partie médiane (19) du couvercle (12) amovible est égale ou tout au plus légèrement inférieure à la longueur de l'évidement prévu à cet effet (11) dans la partie de boîtier arrière (7).

4. Boîtier selon l'une des revendications 1 à 3 pour un appareil de mesure, **caractérisé en ce que** la longueur de l'évidement (11) dans la partie de boîtier arrière (7) pour le logement d'un couvercle (12) amovible est supérieure à la largeur correspondante de la partie de boîtier arrière (7) moins les épaisseurs de paroi des parois de boîtier (10) qui y sont adjacentes.

5. Boîtier selon l'une des revendications précédentes pour un appareil de mesure, **caractérisé en ce que** sur les faces intérieures (17) des parois de boîtier (10) adjacentes à l'évidement (11) de la partie de boîtier arrière (7) pour le logement d'un couvercle (12) amovible est prévue respectivement une cavité approximativement en forme d'auge (18) pour le logement du côté latéral (20) du couvercle (12) amovible.

6. Boîtier selon la revendication 5 pour un appareil de mesure, **caractérisé en ce que** l'épaisseur des parois latérales (10) de la partie de boîtier arrière (7) adjacentes à l'évidement (11) pour le logement d'un couvercle (12) amovible est réduite au niveau des cavités en forme d'auge (18).

7. Boîtier selon la revendication 6 pour un appareil de mesure, **caractérisé en ce que** l'épaisseur de paroi réduite au niveau des cavités (18) en forme d'auge est approximativement égale ou inférieure à deux tiers de l'épaisseur de paroi à l'extérieur de ces cavités (18), de préférence égale ou inférieure à un tiers de cette épaisseur de paroi.

8. Boîtier selon l'une des revendications précédentes pour un appareil de mesure, **caractérisé en ce que** la fente (28) servant à l'introduction de la face frontale d'un support de cadran (32) sur la face intérieure (21) du couvercle (12) se transforme sans transition à partir de sa partie médiane (19) en ses côtés (20) latéraux qui y sont reliés et se poursuit jusqu'aux extrémités libres (30, 31) de ces derniers.

9. Boîtier selon l'une des revendications précédentes pour un appareil de mesure, **caractérisé en ce que** les saillies (24-26) en forme de nervure, de ressort ou de lamelle disposées sur la face intérieure (21) du couvercle (12) amovible et/ou les cavités (27, 29) en forme de rainure en amont et/ou en aval de la fente (28) s'y étendant sur la longueur sont ménagées pour l'insertion de la face frontale d'un support de cadran (32).

10. Boîtier selon la revendication 9 pour un appareil de mesure, **caractérisé en ce que** la/les saillie(s) (24-26) en forme de nervure(s), de ressort(s) ou de lamelle(s) et/ou la/les cavité(s) (27, 29) en forme de rainure(s) sont parallèles à la fente (28) pour l'insertion de la face frontale d'un support de cadran (32).

11. Boîtier selon la revendication 9 ou 10 pour un appareil de mesure, **caractérisé en ce que** la/les saillie(s) (24-26) en forme de nervure(s), de ressort(s) ou de lamelle(s) et/ou la/les cavité(s) (27, 29) en forme de rainure(s) présentent par rapport à leur hauteur ou à leur profondeur une section approximativement constante ou se rétrécissent à partir de leur base (au niveau de la face intérieure enveloppante 21, 36) par rapport à leur extrémité éloignée (partie frontale de ressort libre ou fond de rainure).

12. Boîtier selon l'une des revendications 9 à 11 pour un appareil de mesure, **caractérisé en ce que** l'extension en profondeur de la/des saillie(s) (24-26) en forme de nervure(s), de ressort(s) ou de lamelle(s) et/ou de la/des cavité(s) (27, 29) en forme de rainure(s) diminue vers la face avant (8, 14) du boîtier.

13. Boîtier selon l'une des revendications précédentes pour un appareil de mesure, **caractérisé en ce que** la face intérieure (21) du couvercle (12) amovible et/ou la face latéralement extérieure (36) du cache (13) de l'élément frontal (8) diverge latéralement vers l'extérieur vers la face avant (8, 14) du boîtier (3).
